(19) Europäisches Patentamt
European Patent Office
Office européen des brevets

(11) EP 2 899 761 A1

(12) **EUROPEAN PATENT APPLICATION**
published in accordance with Art. 153(4) EPC

(43) Date of publication:
29.07.2015 Bulletin 2015/31

(21) Application number: 13838307.0

(22) Date of filing: 06.09.2013

(51) Int Cl.:
$H01L\ 31/04^{(2014.01)}$     $H01B\ 1/22^{(2006.01)}$

(86) International application number:
PCT/JP2013/074048

(87) International publication number:
WO 2014/045900 (27.03.2014 Gazette 2014/13)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 18.09.2012 JP 2012204323

(71) Applicant: Murata Manufacturing Co., Ltd.
Nagaokakyo-shi, Kyoto 617-8555 (JP)

(72) Inventor: TAKEI Shodo
Nagaokakyo-shi, Kyoto 617-8555 (JP)

(74) Representative: Behr, Wolfgang
Lorenz Seidler Gossel
Rechtsanwälte - Patentanwälte
Widenmayerstrasse 23
80538 München (DE)

(54) **CONDUCTIVE PASTE AND SOLAR CELL**

(57) The present invention relates to a conductive paste and a solar cell. The conductive paste contains a conductive powder, including at least a silver powder, a glass frit composed mainly of Te, Bi and Zn, and an organic vehicle. The total molar quantity of the three components of Te, Bi and Zn contained in the glass frit is, in terms of oxide, set at 95 mol% or more. Light-receiving surface electrodes (3) are formed by using the above-conductive paste. Thereby, a conductive paste suitable for forming solar cell electrodes is achieved, the conductive paste being capable of reducing both of the contact resistance between the electrodes and the semiconductor substrate, and the line resistance of the electrodes, while being lead free. Furthermore, a solar cell having high energy conversion efficiency and excellent battery characteristics is achieved as a result of using the conductive paste.

**Fig.1**

**Description**

TECHNICAL FIELD

The present invention relates to a conductive paste and a solar cell, and more particularly relates to a conductive paste suitable for forming electrodes of a solar cell and a solar cell produced by using the conductive paste.

BACKGROUND ART

A solar cell usually has light-receiving surface electrodes of a predetermined pattern formed on one side of a main surface of a semiconductor substrate. More, an antireflective film is formed on the semiconductor substrate excluding the above-light-receiving surface electrodes, and the reflection loss of incident solar light is suppressed by the antireflective film, and thereby the conversion efficiency of solar light into electric energy is improved.

By using a conductive paste, the light-receiving surface electrodes is usually formed as follows. That is, the conductive paste contains a conductive powder, a glass frit, and an organic vehicle, and the conductive paste is applied onto a surface of an antireflective film formed on a semiconductor substrate, so that a conductive film having a predetermined pattern is formed. Subsequently, the glass frit is fused in a firing process, and the antireflective film located at a lower layer of the conductive film is decomposed and removed, and thereby the conductive film is sintered to form light-receiving surface electrodes, and the light-receiving surface electrodes and the semiconductor substrate are adhered, thereby electrically coupling them.

As described above, a method of decomposing and removing the antireflective film to adhere the semiconductor substrate and the light-receiving surface electrodes in a firing process is called a fire-through, and the conversion efficiency of a solar cell is largely dependent on the fire-through performance. That is, it is known that, when the fire-through performance is insufficient, the conversion efficiency is reduced, consequently basic performance as a solar cell is inferior.

More, in this kind of a solar cell, it is preferred to use a low-softening point glass frit in order to enhance adhesive strength between the light-receiving surface electrodes and the semiconductor substrate.

As the low-softening point glass frit, Conventionally, a lead-based glass frit has been used. However the environmental burden of lead is large, and thus, the development of new materials in place of the lead-based glass frit has been required.

On the other hand, since the conversion efficiency of a solar cell is largely dependent on the fire-through performance, as described above, it is feared that, when the fire-through advances excessively so that the sintered light-receiving surface electrodes penetrates through the antireflective film to invade the semiconductor substrate, battery characteristics are deteriorated.

Then, the document 1 proposes a conductive paste for forming electrodes of a solar cell, including a conductive powder composed mainly of silver, a glass frit, an organic vehicle, and a solvent, wherein the glass frit includes a tellurium-based glass frit containing tellurium oxide as a network-forming component.

In the document 1, since the conductive paste contains a tellurium-based glass frit, even when the firing treatment is carried out, the light-receiving surface electrodes obtained after the sintering does not deeply invade the inside of the semiconductor substrate, and therefore the control of the fire-through performance is easy, and thereby a solar cell having good battery characteristics is attempted to realize, while being a lead-free type.

Furthermore, in the document 1, the tellurium-based glass frit contains, if necessary, tungsten oxide and molybdenum oxide in addition to tellurium oxide, and contains any one or more of zinc oxide, bismuth oxide, aluminum oxide and the like, and thereby enlargement of vitrification range and stabilization are designed.

Also, in this kind of a solar cell, to improve the conversion efficiency by lowering a contact resistance between the light-receiving surface electrodes and the semiconductor substrate, it is thought to be important to control the sintering behavior of a conductive powder which is a main component of the light-receiving surface electrodes. That is, there is a thermal shrinkage difference between the semiconductor substrate and the conductive powder, such the thermal shrinkage difference become a main obstructive factor to reduction of the contact resistance. In order to reduce the difference of the thermal shrinkage, it is necessary to control the sintering behavior of the conductive powder. For this purpose, conventionally, the sintering behavior of the conductive powder is controlled by adding an additive into the conductive paste, and thereby the contact resistance between the light-receiving surface electrodes and the semiconductor substrate is lowered.

For example, the document 2 proposes a conductive paste for forming electrodes of a solar cell element, the paste containing conductive particles, an organic binder, a solvent, a glass frit, and a low-melting point metal, wherein the low-melting point metal is Te or Se, and the said Te or Se is contained in an amount of 0.01 to 10 wt%.

In the document 2, Te or Se as the low-melting point metal is further contained in addition to a glass frit of a Bi-B-Ba type composed mainly of $Bi_2O_3$ or the like, and thereby an increase of the contact resistance has been suppressed.

That is, when the low-melting point metal is contained in a conductive paste and the firing treatment is carried out in an ambient atmosphere, the low-melting point metal is easily oxidized, so that an oxide film is easily formed on the surface of the conductive particle in the firing process of the conductive paste. In the document 2, the oxide film is formed on the surface of the conductive particles as described above, and thereby excessive sintering of the conductive particles are suppressed, so that the thermal shrinkage behavior of the conductive powder is made close to that of the semiconductor substrate, and thereby the increase of the contact resistance between the semiconductor substrate and the light-receiving surface electrodes is suppressed.

The document 1: JP No.2011-96747 A (claims 1 and 6, pars. [0021] - [0028])

The document 2: JP No. 4754655 (claim 1, para. [0039]).

SUMMARY OF INVENTION

Technical Problem

In the document 1, the contact resistance between the light-receiving surface electrodes and the semiconductor substrate is lowered by using the conductive paste containing the tellurium-based glass frit, and thereby the improvement of the battery characteristics of the solar cell is attempted. However, the contact resistance is dependent on the composition of the glass frit. That is, since the contact resistance is affected by tellurium oxide, and other additives such as tungsten oxide, molybdenum oxide, and the like, it is difficult to maintain the low contact resistance stably.

On the other hand, when various additives are contained in tellurium oxide to produce composition having high contact resistance, the contact resistance can be lowered by further adding ZnO, ZrO, or the like.

However, in this case, since the line resistance of the light-receiving surface electrodes increases, it is difficult to attain a solar cell having a desired high conversion efficiency.

In the document 2, although the contact resistance is lowered by further adding Te or Se in addition to the glass frit, the line resistance cannot be sufficiently lowered because the low-melting point metal such as Te or Se is contained as a sintering suppressor for suppressing excessive sintering of the electrodes, and therefore, it is difficult to attain a solar cell having a desired high conversion efficiency, similarly to the document 1.

The present invention has been made in view of such a situation, and it is an object of the present invention to provide a conductive paste suitable for forming solar cell electrodes that is capable of reducing both of the contact resistance between the electrodes and the semiconductor substrate, and the line resistance of the electrodes, while being lead free, and a solar cell having high energy conversion efficiency and excellent battery characteristics by using the conductive paste.

Solution to Problem

In order to achieve the above-object, the inventor has made studies, and a conductive paste is prepared to have a total amount of three components of Te, Bi and Zn in glass frit is, in terms of oxide, set at 95 mol% or more, and then the conductive paste is sintered to form electrodes, and consequently have found that both of the contact resistance between the electrodes and the semiconductor substrate, and the line resistance of the electrodes can be lowered, and thereby a solar cell having high energy conversion efficiency and excellent battery characteristics can be attained.

The present invention has been made based on such findings, and the conductive paste according to the invention is characterized by a conductive paste for forming electrodes of a solar cell, containing at least a conductive powder, a glass frit containing Te, Bi and Zn as main components, and an organic vehicle, wherein a total molar content of Te, Bi and Zn in the glass frit is, in terms of oxides, set at 95 mol% or more.

In the conductive paste of the present invention, it is preferable that, in the glass frit, a molar content of Te is 35 to 89 mol%, a molar content of Bi is 1 to 20 mol%, and a molar content of Zn is 5 to 50 mol%, in terms of oxide, respectively.

Thereby, vitrifying easily, so that the conductive paste can be attained which is capable of producing a solar cell having both of the low contact resistance and the low line resistance of electrodes, and excellent characteristics by acting the respective glass components of Te, Bi and Zn in the firing process.

In the conductive paste of the present invention, it is also preferable that an additive containing at least one element selected from the group of Si, B, Al, Zr, Ba, Mo and La is included in the glass frit.

Thereby, it is possible to improve the chemical durability and to adjust thermophysical property of the glass frit easily.

In the conductive paste of the present invention, a content of the additive in the glass frit is preferably less than 5 mol%.

Thereby, it is possible to improve the chemical durability without increasing the contact resistance and/or increasing the line resistance.

In the conductive paste of the present invention, a content of the glass frit is preferably 1 to 10 wt%.

Thereby, it is possible to attain a conductive paste having excellent bondability between electrodes and a semiconductor substrate, and excellent solderability.

In the conductive paste of the present invention, the conductive powder is preferably an Ag powder.

Thereby, it is possible to attain electrodes having excellent conductivity even when the conductive paste is fired in an ambient atmosphere.

Furthermore, the solar cell according to the present invention is characterized by an antireflective film and electrodes which penetrates through the antireflective film are formed on one side of a main surface of a semiconductor substrate, wherein the electrodes is formed by sintering the conductive paste described in any one of the above.

Advantageous Effects of Invention

In accordance with the conductive paste of the present invention, the glass frit is crystallized at a low temperature relatively in the firing process, and the crystallized product is intervened in the conductive powder, and then, the excessive sintering of the electrodes can be suppressed because the conductive paste contains at least a conductive powder, a glass frit containing Te, Bi and Zn as main components, and an organic vehicle, and the total molar content of Te, Bi and Zn in the glass frit is, in terms of oxide, set at 95 mol% or more. And thereby, the shrinkage behavior of the conductive powder is made close to that of the semiconductor substrate, so that the contact resistance between the semiconductor substrate and the electrodes can be lowered. After that, when the firing temperature is raised, the crystallized product is remelted and fluidized after the electrodes and the semiconductor substrate are contacted, and thereby the sintering of the conductive powder is advanced, and it is possible to lower the line resistance of the electrodes after the sintering.

As described above, the present conductive paste makes it possible to lower both of the contact resistance between the electrodes and the semiconductor substrate, and the line resistance of the electrodes.

Furthermore, in accordance with the solar cell of the present invention, both of the contact resistance between the electrodes and the semiconductor substrate and, the line resistance of the electrodes can be lowered because an antireflective film and an electrodes which penetrate through the antireflective film are formed on one side of a main surface of a semiconductor substrate, and the electrodes is formed by sintering the above-conductive paste, and thereby it is possible to attain to the solar cell having high energy conversion efficiency and excellent battery characteristics.

BRIEF EXPLANATION OF DRAWINGS

Fig. 1 is a cross-sectional view of a principal portion showing one embodiment of a solar cell produced by using a conductive paste according to the present invention.
Fig. 2 is an enlarged plan view schematically showing a light-receiving surface electrodes side.
Fig. 3 is an enlarged bottom view schematically showing a backside electrodes side.

DESCRIPTION OF EMBODIMENTS

An embodiment of the present invention will be described in detail.

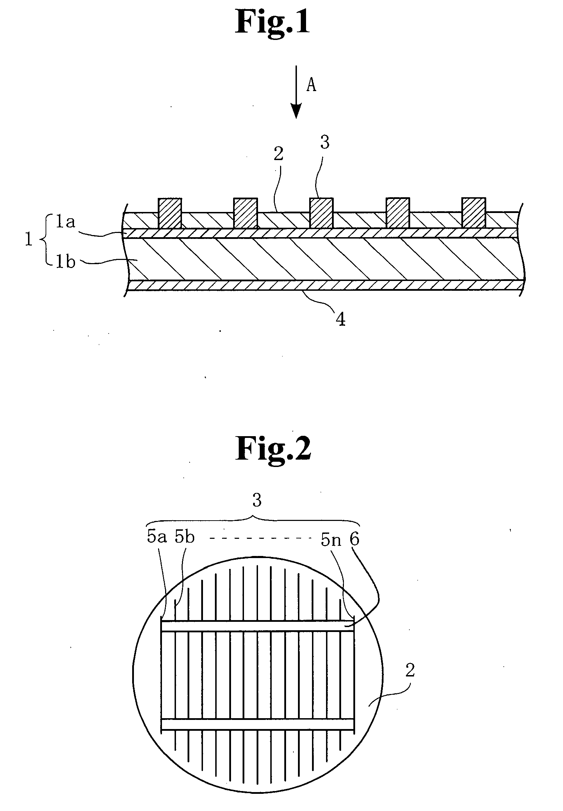

Fig.1 is a cross-sectional view of a principal portion showing an embodiment of a solar cell produced by using a conductive'paste of the present invention.

In this solar cell, an antireflective film 2 and a light-receiving surface electrodes 3 are formed on one side of main surface of a semiconductor substrate 1 composed mainly of Si, and further a backside electrodes 4 is formed on other side of the main surface of the semiconductor substrate 1.

The semiconductor substrate 1 has a p-type semiconductor layer 1b and an n-type semiconductor layer 1a, and the n-type semiconductor layer 1a is formed on the upper surface of the p-type semiconductor layer 1b.

The semiconductor substrate 1 can be obtained, for example, by diffusing impurities into one side of the main surface of the p-type semiconductor layer 1b of a monocrystal or polycrystal, and thereby a thin n-type. semiconductor layer 1a formed. Further, the semiconductor substrate 1 is not particularly limited regarding the structure and the production method thereof as long as the n-type semiconductor layer 1a is formed on the upper surface of the p-type semiconductor layer 1b. The semiconductor substrate 1 may be use substrate having a structure such that a thin p-type semiconductor layer is formed on one side of the main surface of an n-type semiconductor layer, or a structure such that both of a p-type semiconductor layer and an n-type semiconductor layer are formed on a part of one side of the main surface of the semiconductor substrate 1. In any case, the conductive paste of the present invention can be used effectively as long as the main surface of the semiconductor substrate 1 on which is formed the antireflective film 2 is applied.

In Fig.1, although the surface of the semiconductor substrate 1 is illustrated to a flat-shape, the surface is formed so as to have a texture structure in order to confine solar light into the semiconductor substrate 1 effectively.

The antireflective film 2 is composed of an insulating material such as a silicon nitride (SiNx), and suppresses reflection of solar light showed by an arrow A on the light-receiving surface to guide solar light promptly and effectively to the semiconductor substrate 1. The material composed of the antireflective film 2 is not limited to the silicon nitride, and other insulating. materials, for example, a silicon oxide or a titanium oxide, may be used, and also a combination of two or more insulating materials may be used. Further, any one of single crystal Si and polycrystal Si may be used as long as it is a crystal Si-based material.

The light-receiving surface electrodes 3 is formed on the semiconductor substrate 1 to penetrate through the antireflective film 2. The light-receiving surface electrodes 3 is formed by using screen printing or the like, applying the conductive paste of the present invention described later onto the semiconductor substrate 1 to produce a conductive film, and subsequently firing. That is, the antireflective film 2 located at the lower layer of the conductive film is decomposed and removed to undergo a fire-through in the firing step of forming the light-receiving surface electrodes 3, and thereby the light-receiving surface electrodes 3 are formed on the semiconductor substrate 1 in the form of penetrating through the antireflective film 2.

Specifically, as illustrated in Fig. 2, in the light-receiving surface electrodes 3, many finger electrodes 5a, 5b, ...... 5n are arranged in parallel in a comb-teeth shape, and a bus bar electrode 6 is arranged to intersect the finger electrodes 5a, 5b, ... ... 5n. The finger electrodes 5a, 5b, ...... 5n are electrically connected to the bus bar electrode 6. The antireflective film 2 is formed in a remaining area excluding a portion where the light-receiving surface electrodes 3 is provided. In this way, the electric power generated in the semiconductor substrate 1 is collected through the finger electrodes 5a, 5b, ...... 5n, and extracted to the outside through the bus bar electrode 6.

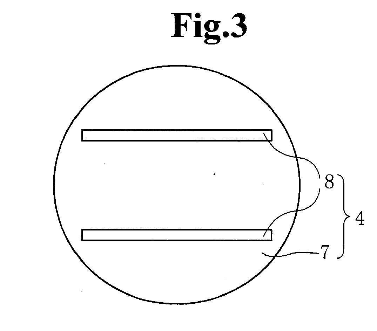

The backside electrode 4, as illustrated in Fig.3, specifically, consists of a collecting electrode 7 composed of A1 or the like which is formed on the back surface of the p-type semiconductor layer 1b, and extraction electrodes 8 composed of Ag or the like which is connected electrically to the collecting electrode 7. The electric power generated in the semiconductor substrate 1 is collected to the collecting electrode 7, and then extracted the electric power through the extraction electrodes 8.

Next, the conductive paste of the present invention for forming the light-receiving surface electrodes 3 will be described in detail.

The conductive paste of the present invention contains at least a conductive powder, a Te-Bi-Zn based glass frit containing Te, Bi and Zn as main components, and an organic vehicle.

The total molar content of three components of Te, Bi and Zn in the glass frit is, in terms of oxide, set at 95 mol% or more.

Thereby, it is possible to lower both of the contact resistance between the light-receiving surface electrodes 3 and the semiconductor substrate 1, and the line resistance of the electrodes, and consequently being capable of obtaining a solar cell having high energy conversion efficiency and excellent battery characteristics.

In the firing process, The glass frit containing Te, Bi and Zn as main components is crystallized in a low temperature range relatively to precipitate a crystallized product, after that, the product is remelted when the firing temperature is raised.

Specifically, in the firing process, the glass frit containing three components of Te, Bi and Zn as main components is crystallized in a low temperature range relatively, for example 400 - 500°C, to precipitate a crystallized product of a composite oxide containing at least two of the three components such as $Zn_2Te_3O_8$, $Bi_2Te_4O_{11}$, $Bi_2Te_2O_7$, or the like. By mediating the crystallized product composed of the composite oxide among particles of the conductive powder, the excessive sintering of the light-receiving surface electrodes 3 can be suppressed. As a result, the shrinkage behavior of the conductive powder is made close to that of the semiconductor substrate 1, and thereby the contact resistance between the semiconductor substrate 1 and the light-receiving surface electrodes 3 can be lowered.

Thereafter, the firing temperature is raised, the light-receiving surface electrodes 3 and the semiconductor substrate 1 contact each other, and subsequently when the temperature reaches a predetermined high-temperature range, for example 540 - 750°C, the crystallized product is remelted and fluidized. Thereby, the sintering of the conductive powder is advanced, and can be formed the light-receiving surface electrodes having low line resistance.

As described above, since the present conductive paste can be lowered both of the contact resistance and the line resistance, it is possible to attain a solar cell having high energy conversion efficiency and excellent battery characteristics by using the conductive paste.

In addition, although the glass frit may contain components other than the three components - i.e. Te, Bi and Zn, it is necessary that the total molar content of the three components in the glass frit is, in terms of oxide, set at 95 mol% or more

When the total molar content of the three components in the glass frit is less than 95 mol%, the content of the components other than the above-three components is increased, so that the crystallized product which contains the components other than the three components may be produced. As a result, the contact resistance or the line resistance of the electrodes cannot be sufficiently lowered, so that a solar cell having a desired high conversion efficiency cannot be attained.

Although molar content of each of the three components in the glass frit is not particularly limited, it is preferred that the molar content of Te is 35 to 89 mol% in terms of $TeO_2$ the molar content of Bi is 1 to 20 mol% in terms of $Bi_2O_3$, and the molar content of Zn is 5 to 50 mol% in terms of ZnO, in view of realizing the desired vitrification of the glass frit.

As described above, the glass frit may contain additives other than the three components. In particular, when the glass frit includes a compound containing Si, B, A1, Zr, Ba, Mo and/or La, and further containing, for example, P, V, Ti, Li, Na, K, Mg, Sr, Ca, Ce, Cr, Mn, Co, Ni, Cu, Nb, Ta, W, Pd, Ag, Ru, Sn, In, Y and/or Dy, the glass frit can be improved in chemical durability, and further the thermophysical property of the glass frit can be adjusted easily.

In addition, when these additives contain the glass frit, the molar content thereof is preferably less than 5 mol%, more preferably less than 3 mol%.

When the molar content of each of these additives is more than 5 mol% in the glass frit, it is feared, on the contrary, that the chemical durability may be lowered. Furthermore, since the total molar content of Te, Bi and Zn is lowered to less than 95 mol% in the glass frit, the crystallized product other than the above-mentioned composite oxide is produced in the firing process, so that the conductive powder is changed in shrinkage behavior such as the occurrence of an excessive sintering reaction, as a result, the contact resistance and/or the line resistance may be caused an increase.

Besides, the addition form of these additives is not particularly limited, and the additive may be added in the form of, for example, an oxide, a hydroxide, a peroxide, a halide, a carbonate, a nitrate, a phosphate, a sulfate or a fluoride.

Although the content of the glass frit in the conductive paste is not particularly limited, it is preferably 1 to 10 wt%, more preferably 1 to 5 wt%. When the content of the glass frit is less than 1 wt%, the bondability between the electrodes and the semiconductor substrate may be lowered. On the other hand, when the content of the glass frit is more than 10 wt%, the glass component is excessively present on the electrodes surface after the firing, thereby causing the degradation of the solderability.

Although the conductive powder is not particularly limited as long as it is a metal powder having excellent electric conductivity, an Ag powder which can maintain excellent electric conductivity without being oxidized even when the firing treatment is carried out in an ambient atmosphere, may be preferably used. In addition, the shape of the conductive powder is not particularly limited, and, for example, a spherical shape, a flattened shape, or an amorphous shape, or a mixture thereof can be used.

Although the average particle diameter of the conductive powder is not particularly limited, it is preferably 0.5 to 5.0 $\mu$m, in terms of a spherical powder, in view of ensuring a desired contact point between the conductive powder and the semiconductor substrate 1.

More, although the content of the conductive powder in the conductive paste is not particularly limited, it is preferably 80 to 95 wt%. When the content of the conductive powder is less than 80 wt%, a film thickness of the electrodes becomes small, as a result, the line resistance tends to increase. On the other hand, when the content of the conductive powder is more than 95 wt%, the content of the organic vehicle or the like is decreased, and therefore pasting becomes difficulty.

The organic vehicle is prepared in such a manner that a volume ratio between a binder resin and an organic solvent is, for example, 1:9 to 3:7. The binder resin is not particularly limited, and for example, an ethylcellulose resin, a nitrocellulose resin, an acrylic resin, an alkyd resin, and any combination of two or more of these resins can be used. The organic solvent is not particularly limited, and texanol, $\alpha$-terpineol, xylene, toluene, diethylene glycol monobutyl ether, diethylene glycol monobutyl ether acetate, diethylene glycol monoethyl ether, and diethylene glycol monoethyl ether acetate and the like can be used singly, or in combination thereof.

In addition, it is also preferred to add, a kind of plasticizer such as diethylhexyl phthalate or dibutyl phthalate, or a combination of two or more thereof in the conductive paste, if necessary. It is also preferred that a rheology-adjusting agent such as fatty acid amide or fatty acid is added, and further a thixotropic agent, a thickening agent, a dispersing agent or the like may be added.

The conductive paste can be easily produced by weighing and mixing the conductive powder, the glass frit, the organic vehicle, and various additives, if necessary, so as to have a predetermined mixture ratio, and dispersing and kneading by using a triple roll mill or the like.

As described above, in the present embodiment, the glass frit is crystallized at a low temperature relatively in the firing process, and furthermore the crystallized product is intervened in the conductive powder, and then, the excessively sintering of the electrodes is suppressed because the conductive paste contains at least a conductive powder made of Ag and the like, a glass frit containing Te, Bi and Zn as main components, and an organic vehicle, and the total molar content of Te, Bi and Zn in the glass frit is, in terms of oxide, set at 95 mol% or more. And thereby, the shrinkage behavior of the conductive powder is made close to that of the semiconductor substrate 1, so that it is possible to lower the contact resistance between the semiconductor substrate 1 and the light-receiving surface electrodes 3. Furthermore, thereafter, the firing temperature is raised, and after the light-receiving surface electrodes 3 and the semiconductor substrate 1 contact each other, the crystallized product is remelted and fluidized, and thereby the sintering of the conductive powder is advanced, the line resistance of the electrodes after the sintering can be lowered.

As described above, in the present conductive paste, it is possible to lower both of the contact resistance between the light-receiving surface electrodes 3 and the semiconductor substrate 1, and the line resistance of the electrodes.

In the present solar cell, it is possible to lower both of the contact resistance between the light-receiving surface electrodes 3 and the semiconductor substrate 1, and the line resistance of the light-receiving surface electrodes 3 because the antireflective film 2 and the light-receiving surface electrodes 3 which penetrates through the antireflective film 2 are formed on one side of main surfaces of the semiconductor substrate 1, and the light-receiving surface electrodes 3 is formed by sintering the above-conductive paste. Thereby, the solar cell having high energy conversion efficiency and excellent battery characteristics can be attained.

Besides the present invention is not limited to this embodiment. In the above-embodiment, although the conductive paste is used for forming the light-receiving surface electrodes, it may be further used for forming the backside electrode.

Next, examples of the present invention will be described specifically.

EXAMPLE

Production of Samples

(Production of conductive paste)

As materials for glass, $TeO_2$ $Bi_2O_3$, ZnO, $Al_2O_3$, $ZrO_2$, $SiO_2$, $B_2O_3$, BaO, $MoO_3$ and $La_2O_3$ were prepared. These glass materials were weighed and prepared to have a blend proportion, as shown in Table 1, and thereby a glass frit of sample Nos. 1 to 14 was produced respectively.

Table 1

| Sample No. | Glass composition (mol%) | | | | | | | | | |
|---|---|---|---|---|---|---|---|---|---|---|
| | $TeO_2$ | $Bi_2O_3$ | ZnO | $Al_2O_3$ | $ZrO_2$ | $SiO_2$ | $B_2O_3$ | BaO | $MoO_3$ | $La_2O_3$ |
| 1 | 89.0 | 1.0 | 9.6 | 0.4 | - | - | - | - | - | - |
| 2 | 70.0 | 4.5 | 25.0 | 0.5 | - | - | - | - | - | - |
| 3 | 36.0 | 13.6 | 50.0 | 0.4 | - | - | - | - | - | - |
| 4 | 81.5 | 10.5 | 7.6 | 0.4 | - | - | - | - | - | - |
| 5 | 60.3 | 11.5 | 27.9 | 0.3 | - | - | - | - | - | - |
| 6 | 50.2 | 9.8 | 39.6 | 0.4 | - | - | - | - | - | - |
| 7 | 55.0 | 19.9 | 24.3 | 0.8 | - | - | - | - | - | - |
| 8 | 60.0 | 15.0 | 25.0 | - | - | - | - | - | - | - |
| 9 | 44.8 | 12.8 | 37.7 | - | - | 2.8 | - | 1.9 | - | - |
| 10 | 53.4 | 19.5 | 22.5 | - | 1.8 | - | 2.8 | - | - | - |
| 11* | 75.3 | 5.7 | 12.5 | - | - | - | - | - | 6.5 | - |
| 12* | 50.0 | - | 25.0 | - | - | - | - | - | - | 25.0 |
| 13* | 70.0 | 10.0 | - | - | - | - | - | - | 20.0 | - |
| 14* | - | 80.0 | - | - | - | - | 10.0 | 10.0 | - | - |
| * indicates outside the scope of the present invention. | | | | | | | | | | |

As a conductive powder, a spherical Ag powder having an average particle diameter of 1.6 μm was prepared.

Then, an organic vehicle was produced. That is, an ethyl cellulose resin and texanol were mixed so that an ethyl cellulose resin as a binder resin was 10 wt% and texanol as an organic solvent was 90 wt% to produce an organic vehicle.

Then, 86.0 wt% of the Ag powder and 3.0 wt% of the glass frit were mixed together with a rheology-adjusting agent such as an aliphatic acid amide, aliphatic acid, or the like and the organic vehicle, and the resulting mixture was mixed with a planetary mixer and then kneaded with a triple roll mill to produce conductive pastes of sample Nos. 1 to 13.

Furthermore, 3.0 wt% of a glass frit of sample No. 14, 86.0 wt% of the Ag powder, and 3.0 wt% of $TeO_2$ were mixed together with a rheology-adjusting agent such as an aliphatic acid amide, aliphatic acid or the like, and the organic vehicle, and the resulting mixture was mixed with a planetary mixer and then kneaded with a triple roll mill to produce a conductive paste of sample No. 14.

(Production of solar cells)

An antireflective film having a film thickness of 0.1 $\mu$m was formed on the entire surface of a monocrystal Si-based semiconductor substrate having a length of 50 mm, a width of 50 mm and a thickness of 0.2 mm by plasma-enhanced chemical vapor deposition method (PECVD). In the Si-based semiconductor substrate, a phosphorus (P) is diffused into a part of a p-type Si-based semiconductor layer, and thereby an n-type Si-based semiconductor layer is formed on the upper surface of the p-type Si-based semiconductor layer.

Next, an Al paste composed mainly of Al, and an Ag paste composed mainly of Ag were prepared. The A1 paste and the Ag paste were applied onto the back surface of the Si-based semiconductor substrate appropriately, and the resultant was dried, thereby forming a conductive film for backside electrode.

Next, Using the above-mentioned conductive paste, screen printing was performed, and was applied onto the surface of the Si-based semiconductor substrate so that a film thickness after the firing becomes 20 $\mu$m, and thereby a conductive film for light-receiving surface electrodes was produced.

Next, each of the sample was put into an oven which set to a temperature of 150°C, and dried the conductive film.

Thereafter, with use of a belt-type near infrared furnace (CDF7210, manufactured by Despatch), the conveying speed of the sample was adjusted so that the sample passed through about one minute from the inlet to the outlet, and was fired at a maximum firing temperature of 760 to 800°C in an ambient atmosphere, and thereby a solar cell of sample Nos. 1 to 14 on which the conductive paste was sintered to form light-receiving surface electrodes, was produced respectively. The reason the maximum firing temperature was set to 760 to 800°C is that the maximum firing temperature optimal for such a paste is varied in accordance with the composition thereof.

Evaluation of Samples

In each of the sample Nos. 1 to 14, using a solar simulator (SS-50XIL, manufactured by EKO Instruments), a current-voltage characteristic curve under conditions of a temperature of 25°C and an AM (air mass) of 1.5 was measured, and then, the fill factor FF of the sample was calculated based on the current-voltage characteristic curve, in accordance with the mathematical formula (1).

$$FF = Pmax/(V_{OC} \times I_{SC}) \quad . \quad . \quad .(1)$$

Wherein Pmax is the maximum power of the sample; $V_{oc}$ is an open-circuit voltage generated when the output terminals are opened; and $I_{sc}$ is a short circuit current generated when the output terminals are short-circuited therebetween.

The conversion efficiency $\eta$ of the sample was calculated based on the maximum power Pmax, an area A of the light-receiving surface electrodes, and an irradiance E,in accordance with the mathematical formula (2).

$$\eta = Pmax \ (A \times E) \quad . \quad . \quad . \quad (2)$$

Table 2 shows the paste composition, the fill factor FF, and the conversion efficiency $\eta$ of the sample Nos. 1 to 14, respectively.

Table 2

| Sample No. | Paste composition (wt%) | | | | Fill factor FF (-) | Conversion efficiency $\eta$ (%) |
|---|---|---|---|---|---|---|
| | Ag | Glass frit | $TeO_2$ | Organic vehicle and others | | |
| 1 | 86.0 | 3.0 | - | 11.0 | 0.781 | 16.71 |
| 2 | 86.0 | 3.0 | - | 11.0 | 0.775 | 16.58 |

(continued)

| Sample No. | Paste composition (wt%) | | | | Fill factor FF (-) | Conversion efficiency $\eta$ (%) |
|---|---|---|---|---|---|---|
| | Ag | Glass frit | TeO$_2$ | Organic vehicle and others | | |
| 3 | 86.0 | 3.0 | - | 11.0 | 0.784 | 16.77 |
| 4 | 86.0 | 3.0 | - | 11.0 | 0.769 | 16.45 |
| 5 | 86.0 | 3.0 | - | 11.0 | 0.771 | 16.49 |
| 6 | 86.0 | 3.0 | - | 11.0 | 0.776 | 16.60 |
| 7 | 86.0 | 3.0 | - | 11.0 | 0.773 | 16.53 |
| 8 | 86.0 | 3.0 | - | 11.0 | 0.770 | 16.45 |
| 9 | 86.0 | 3.0 | - | 11.0 | 0.770 | 16.44 |
| 10 | 86.0 | 3.0 | - | 11.0 | 0.776 | 16.66 |
| 11* | 86.0 | 3.0 | - | 11.0 | 0.755 | 16.12 |
| 12* | 86.0 | 3.0 | - | 11.0 | 0.752 | 16.08 |
| 13* | 86.0 | 3.0 | - | 11.0 | 0.712 | 15.21 |
| 14* | 86.0 | 3.0 | 3.0 | 8.0 | 0.733 | 15.67 |
| * indicates outside the scope of the present invention. | | | | | | |

In the sample No. 11, the fill factor FF was as low as 0.755, and the conversion factor $\eta$ was as low as 16.12%. The reason for this is thought that, although the glass frit contains TeO$_2$, Bi$_2$O$_3$ and ZnO, the total molar content thereof is as small as 93.5 mol% in the glass frit, and the content of MoO$_3$ in the glass frit is 6.5 mol% and it is contained excessively, a crystallized product containing Mo other than Te, Bi and Zn is produced, and consequently the excessive sintering of the conductive powder cannot be suppressed.

In the sample No. 12, since La$_2$O$_3$ was contained in the glass frit in place of Bi$_2$O$_3$, the fill factor FF was as low as 0.752, and the conversion efficiency $\eta$ was as low as 16.08%.

In the sample No. 13, since MoO$_3$ was contained in the glass frit in place of ZnO, the.fill factor FF was as low as 0.712, and the conversion efficiency $\eta$ was as low as 15.21%.

Since sample No. 14 was further added to TeO$_2$ in addition to the Bi-B-Ba based glass frit, similarity to the document 2, the line resistance was unable to be made small, so that the fill factor FF was as low as 0.733, and also the conversion efficiency $\eta$ was as low as 15.67%.

On the other hand, although the sample Nos. 1 to 10 is contained additives such as Al$_2$O$_3$, ZrO$_2$ SiO$_2$, B$_2$O$_3$ and BaO in a slight amount, the total molar content of TeO$_2$, ZnO and Bi$_2$O$_3$ was 95 mol% or more in the glass frit, accordingly it was understood that the contact resistance was able to be lowered, and the line resistance was also low, and as a result, a solar cell was attained in which the fill factor FF was as excellent as a value of 0.769 to 0.781 and the conversion efficiency $\eta$ was as high as a value of 16.44 to 16.77%.

INDUSTRIAL APPLICABILITY

even when a lead-free type conductive paste is used, both of the contact resistance between the electrodes and the semiconductor substrate, and the line resistance of the electrodes can be lowered, thereby capable of obtaining a solar cell with high energy conversion efficiency.

REFERENCE SIGNS LIST

1    Semiconductor substrate
2    Antireflective film
3    Light-receiving surface electrodes

**Claims**

1. A conductive paste for forming electrodes of a solar cell, comprising at least a conductive powder, a glass frit containing Te, Bi and Zn as main components, and an organic vehicle,
   wherein a total molar content of Te, Bi and Zn in the glass frit is, in terms of oxide, set at 95 mol% or more.

2. The conductive paste according to claim 1, wherein a molar content of Te is 35 to 89 mol%, a molar content of Bi is 1 to 20 mol%, and a molar content of Zn is 5 to 50 mol% in the glass frit, in terms of oxide, respectively.

3. The conductive paste according to claim 1 or 2,wherein an additive containing at least one element selected from the group of Si, B, Al, Zr, Ba, Mo and La is included in the glass frit.

4. The conductive paste according to claim 3, wherein a content of the additive in the glass frit is less than 5 mol%.

5. The conductive paste according to any one of claims 1 to 4, wherein a content of the glass frit is 1 to 10 wt%.

6. The conductive paste according to any one of claims 1 to 5, wherein the conductive powder is an Ag powder.

7. A solar cell comprising a semiconductor substrate, an antireflective film and electrodes penetrated through the antireflective film are formed on one side of a main surface of a semiconductor substrate,
   wherein the electrodes is formed by sintering the conductive paste according to any one of claims 1 to 6.

# Fig.1

# Fig.2

# Fig.3

## INTERNATIONAL SEARCH REPORT

| | International application No. |
|---|---|
| | PCT/JP2013/074048 |

**A. CLASSIFICATION OF SUBJECT MATTER**
*H01L31/04*(2006.01)i, *H01B1/22*(2006.01)i

According to International Patent Classification (IPC) or to both national classification and IPC

**B. FIELDS SEARCHED**

Minimum documentation searched (classification system followed by classification symbols)
H01L31/04, H01B1/22

Documentation searched other than minimum documentation to the extent that such documents are included in the fields searched
| Jitsuyo Shinan Koho | 1922–1996 | Jitsuyo Shinan Toroku Koho | 1996–2013 |
| Kokai Jitsuyo Shinan Koho | 1971–2013 | Toroku Jitsuyo Shinan Koho | 1994–2013 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2011-96748 A  (Shoei Chemical Inc.), 12 May 2011 (12.05.2011), entire text; all drawings & US 2011/0094578 A1    & EP 2317561 A2 & CA 2718207 A        & CN 102082187 A & TW 201126731 A | 1-7 |
| A | WO 2010/016186 A1  (Kyoto Elex Co., Ltd.), 11 February 2010 (11.02.2010), entire text; all drawings & JP 2010-283340 A       & US 2011/0192457 A1 & EP 2323171 A1          & KR 10-2010-0075661 A & CN 101828267 A         & TW 201007957 A & KR 10-2012-0032573 A | 1-7 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 19 September, 2013 (19.09.13) | 01 October, 2013 (01.10.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2013/074048

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2011-510897 A  (BASF SE),<br>07 April 2011 (07.04.2011),<br>entire text; all drawings<br>& US 2009/0189126 A1     & US 2010/0244205 A1<br>& WO 2009/097264 A1       & CA 2712348 A<br>& CN 101932535 A          & KR 10-2010-0125273 A<br>& IL 206987 D             & RU 2010135771 A | 1-7 |

Form PCT/ISA/210 (continuation of second sheet) (July 2009)

**EP 2 899 761 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011096747 A

- JP 4754655 B